# EUROPEAN PATENT APPLICATION

(11) **EP 4 465 777 A1**
(43) Date of publication of application: **20.11.2024**
(21) Application number: 23173779.2
(22) Date of filing: 16.05.2023
(51) Int. Cl.: H05K 5/00, H05K 5/02

(54) **WIRE GUIDE IN AN ELECTRONIC CONTROL UNIT**

(71) Applicant: Aptiv Technologies AG, 8200 Schaffhausen (CH)
(72) Inventor: Ogorzaly, Artur, Dublin, 2 (IE); Swiercz, Karol, Dublin, 2 (IE); Kupczyk, Pawel, Dublin, 2 (IE)
(74) Representative: Lewis Silkin LLP

(57) **Abstract**

An electronic control unit, ECU (10), comprises: a housing (11) for housing a first electronic device (15), such as a PCB/processor, and a second electronic device (19), such as a fan unit, connected to each other by a cable (18). A cavity (20) within the housing accommodates part of the cable (18) and includes a hook shaped guide element (21) that engages with the cable and prevents it from becoming trapped against a cover (12) during assembly.

## Description

### Introduction

The present disclosure relates to a wire guide for use in an electronic control unit (ECU), i.e. where wires are required to be routed between electric components/devices within an ECU during assembly.

### Background

When electronic components/devices/modules are assembled into a housing, i.e. an electronic control unit (ECU), various wiring must be managed for proper integration. One such example is the mounting of a fan unit at a side wall of the unit, for providing airflow to components within, where a power/control cable must connect between the fan motor and control device on a printed circuit board (PCB). Each fan unit or other device type will have different cable characteristics and may require bespoke surface features in the housing for guidance to its destination. In other words, if a new device is to be installed, wire guidance must be adjusted which creates issues in serial production.

Furthermore, during normal assembly, the cable is manually routed into the housing for connection to the PCB, followed by closing the unit by use of a cover plate which is secured by fixing screws. In some cases, the cable/wire(s) may be inadvertently trapped between metal surfaces and can be damaged and/or cause short circuits. Even when a cable is guided, such as between two upstanding pedestal features, it can pop out and be caught between the pedestal and cover or become loose, thereby being prone to shaking/rattling during use of the device.

The present disclosure seeks to address issues with conventional wire guide solutions in ECUs or at least provide an alternative configuration for manufacturers of such devices.

### Summary

According to a first aspect, a wire guide feature in a housing in an electronic control device is provided according to claim 1. In an exemplary form when assembled, the electronic control unit may comprise: a housing for housing a first electronic device and provision for a second electronic device; a cavity within the housing, for accommodating at least part of a length of a cable electrically communicating between the first and second electronic devices; a cover for providing a closure to the cavity and fixable to the housing; further comprising a hook shaped cable guide extending from or adjacent a wall of the cavity and configured for receiving at least part of the length of the cable.

In this way, the invention is directed to an electronic control unit's housing, configured to receive at least one internal electronic device. The housing provides an inherent/integral cable management feature, in the form of an overhanging element at the cavity, i.e. the hook shaped guide, which is able to guide, during assembly and subsequent use, a cable connecting a peripheral electronic device to the at least one internal electronic device. The electronic devices and cable(s) may be features combined with the housing, for the purposes of determining scope.

The cable guide holds the cable in a separated position, i.e. disposed at a distance, from the cover or similar element. In embodiments, the cable is to be guided underneath the hook shaped guide, so that the thickness of the hook provides a dividing element between the cable and the cover, when in place. In this way, the cable is prevented from being trapped between the cover and another surface, e.g. a metal surface of the housing or corresponding surface feature, which may cause damage and/or a short circuit. The hook shape of the guide provides a convenient interface which captures a cable/wire. The cable/wire may be comprised of multiple wires and associated shielding/cladding.

Accordingly, the invention is directed to a standardized approach for wiring electronic control units, thus streamlining production and avoiding extra cost for design changes. The solution is a simple feature but exemplifies a number of benefits, as mentioned above.

In embodiments, the first electronic device is comprised of a PCB having a connector configured to receive a mating connector of the cable. The second electronic device may have a hard wired or connected cable, which includes the mating connector at its distal end. In embodiments, the second electronic device may be a fan unit, mounted into or onto the housing of the ECU.

In embodiments, an internal dimension/shape of the hook is compatible with the cable, e.g. to hold it securely in an interference fit. In this way, the dimension of the hook is suited to its application and for compatibility with a range of secondary peripheral devices, which may typically have varying lengths of cable, but often a similar width/radius.

In embodiments, the internal shape is a radius, i.e. round/curved, to be compatible with a tubular cable. However, alternative cross-sections are possible. An external radius or surface of the hook may be curved or otherwise configured to fit under the cover, such as by being flat, without obstruction thereto.

In embodiments, the internal shape/radius/dimension of the hook is selected to enclose/surround approximately half of the circumference of the associated cable it is to guide or, put another way, an opening or gap in the hook is chosen to be at least more than a quarter, or less than three quarters. Any less engagement and the cable may slip out of its secured position for assembly, any less gap and the assembly procedure may be complicated by having to force the cable into the hook's opening.

In embodiments, the cavity may have a depth up to 30mm. A clearance may be present between the hook's upper/outer surface/edge and the cover, e.g. up to 5mm, but is generally sought to be minimised. The hook's internal diameter may be from 0.4mm up to 2.5mm. In general, the radius is adapted to the cable dimensions or vice-versa. The hook's width (i.e. in plan view) may be from 1mm up to 40mm. Preferably, the hook is not too wide otherwise it may not be suited to capturing a wire which twisted/coils in various directions.

In embodiments, an edge of the cavity and/or edge/surface of the cover, includes a seal material. In this way, the cavity and cable may be protected from fluid ingress.

The present disclosure is directed to the functionality of a circuit arrangement within a housing, particularly a housing for an electronic control unit or device that may also serve as a heat sink for components attached/housed to it. The core elements of the circuit and method of assemblage are described, particularly in the context of automotive control systems.

As alluded to in the background section above, there are currently many different solutions in the market for electronic components to be connected within an ECU. For example, in the context of a fan unit that is required to be integrated into an ECU, fan wire length and/or fan wire protections vary. The solution of the present disclosure is a feature added to the structure of the housing itself, e.g. a die cast/moulded box which serves as a heat sink for internal components. The solution is effective, independent of wire length and/or tube protection present. Cables connecting between components, compatible with the overhanging guide, may be shielded, have multiple strands and many different diameters. The precise design of cable is not a limiting feature of the invention.

Since the hook design is agnostic to wire length/wire protection change/wire twisting, it allows use of the same size fan or other peripheral unit without additional modification in wire or any additional fixes as a new part. Accordingly, protection of the cable/wire is no longer a barrier to implementing a different fan unit or similar. The design especially reduces potential for short circuiting on the wire during assembly. Since various fan wire protection designs may be presently offered by supplier companies, the present invention allow a single wire protection solution to be implemented for compatible devices to be connected with the ECU or a PCB therein. In other words, the solution is independent of device (e.g. fan unit) design.

In view of the invention, the common problems of device wire guiding are solved by a simple hook surface feature adjacent a cavity through or within which part of the length of the cable must be housed. The hook is a surface structure added to the diecast to hold a wire during the assembly process in a fixed position, i.e. avoiding wire movement during assembly. Such an elegant solution prevents the connecting wire from damage which may result from collision with rest of the assembly.

The ECU described herein is applicable for metal (e.g. aluminium/magnesium/zinc) die cast and for plastics materials. Design limitations, e.g. dimensions, can be assessed by a skilled person in relation to the type of components to be housed and use situation.

Notably, while the main context described herein is a wire guided from an external location (e.g. a fan unit) into the housing, for connection to a power/control source, the invention is not limited to such. Routing of cables may take place entirely within the ECU. In this sense, the general purpose is to manage cables within the ECU and prevent conflict with the cover fitted during assembly, by providing a hook at an edge of a cavity for receiving wires.

Furthermore, the context of the invention is the automotive sector, e.g. as a head unit or cluster of devices, but the design is universal to ECUs in general.

Alternatively, the invention can be expressed as an ECU housing comprised of a cavity for receiving electronic components and/or connecting cables, wherein a cable guide overhangs the cavity, for the purpose of separating a cable passing underneath the cable guide from a cover that is affixed over the cavity during assembly.

A second aspect of the invention is embodied by a method according to claim 14.

### Brief Description of Drawings

Illustrative embodiments will now be described with reference to the accompanying drawings in which:
Figure 1 illustrates an overview of an electronic control unit, ECU, housing;
Figure 2 illustrates a plan view of the ECU, with cover plate removed so that internal components/devices are visible;
Figure 3 illustrates a perspective overview of the ECU with cover plate removed; and
Figure 4 illustrates a closer view of a hook shaped guide element according to the invention.

### Detailed Description

The following description presents exemplary embodiments and, together with the drawings, serves to explain principles of the invention. However, the scope of the invention is not intended to be limited to the precise details of the embodiments or exact adherence with all system features and/or method steps, since variations will be apparent to a skilled person and are deemed also to be covered by the description. Terms for components used herein should be given a broad interpretation that also encompasses equivalent functions and features.

In some cases, several alternative terms (synonyms) for structural, system features have been provided but such terms are not intended to be exhaustive. For the avoidance of doubt, any terms separated by the "/" symbol generally refer to alternative "or" expressions where the terms can be used interchangeably. Descriptive terms should also be given the broadest possible interpretation; e.g. the term "comprising" as used in this specification means "consisting at least in part of" such that interpreting each statement in this specification that includes the term "comprising", features other than that or those prefaced by the term may also be present. Related terms such as "comprise" and "comprises" are to be interpreted in the same manner. Any directional terms such as "vertical", "horizontal", "up", "down", "sideways", "upper" and "lower" are used for convenience of explanation usually with reference to the form shown in illustrations and are not intended to be ultimately limiting if an equivalent function can be achieved with an alternative dimension and/or direction. All directional terms are relative to each other.

The description herein refers to embodiments with particular combinations of steps or features, however, it is envisaged that further combinations and cross-combinations of compatible steps or features between embodiments will be possible. Indeed, isolated features may function independently as an invention from other features and not necessarily require implementation as a complete combination.

It will be understood that the illustrated embodiments show uses only for the purposes of explanation. In practice, the invention may be applied to many different configurations, where the embodiment is straightforward for those skilled in the art to implement.

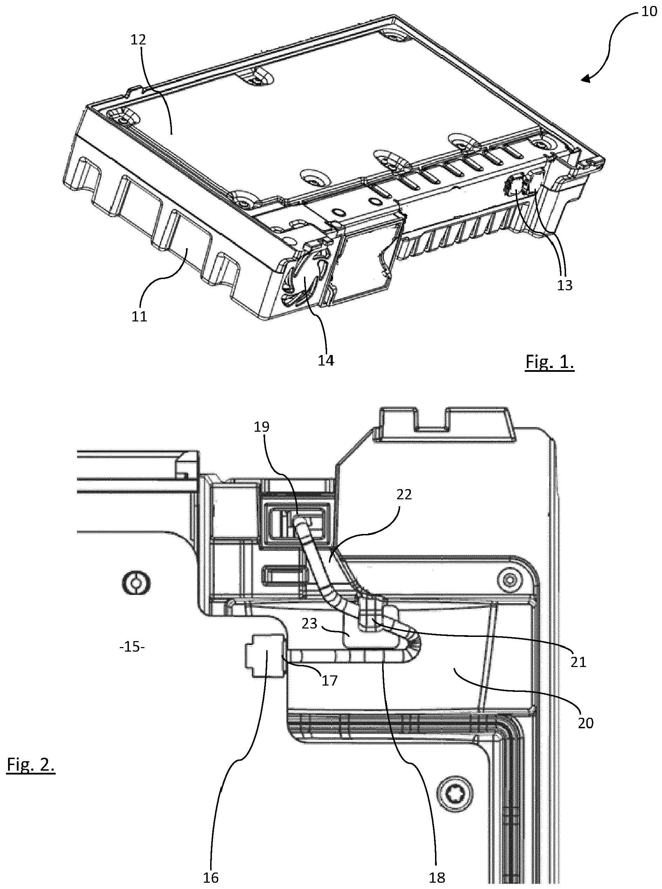

Figure 1 shows an overview of an electronic control unit (ECU) 10 of the type associated with the present invention. Such a unit includes a walled housing 11 for accommodating at least one electronic component/device and a cover plate 12 that is typically removable, e.g. via fixing screws, for enabling internal access during assembly and/or repair. The ECU may also include a number of externally accessible electrical connectors 13 communicating with the internal components and a fan unit 14, located at a peripheral wall and providing a means of circulating air within the housing 11 that cools components. It is also notable that the housing itself may be formed of a heat conductive material to function as a heat sink for internal components.

Figure 2 shows a partial plan view of the ECU where the cover 12 has been removed. The section which is visible shows a first electronic device 15, e.g. a PCB which may support a processor and/or other electronic components, including a first connector 16, configured for receiving a mating cable connector 17, the associated cable 18 of which extends from a second electronic device 19 and provides electrical communication between the devices 15 and 19. In the illustrated form, the second device 19 is a fan unit attached to a side of the housing 11, e.g. having a second connector into which is plugged a mating cable connector, although the cable may be hard wired (i.e. not removable) relative to the fan unit. Electronic communication through cable 18 may provide power, e.g. power to the fan unit, or other signals, e.g. control signals such as fan speed.

The cable 18 that communicates between first and second devices 15/19 may be of various lengths depending on the device and is generally required to be accommodated within a cavity 20 in housing 11, adjacent first device 15. In accordance with the invention, a hook shaped wire guide 21 or overhanging element is located at or proximate a wall of the cavity 20 for the purpose of receiving and guiding cable 18, in this case as it passes from an external location on the housing, through a channel 22, to cavity 20. Hook guide 21 serves to hold down cable 18 to maintain it away from the cavity edges where it could be trapped with cover plate 12. Hook 21 further maintains a twisting and/or turning portion of the cable 18 length within cavity 20.

In the illustrated embodiment hook 21 is positioned over a wider opening 23, however, this structure is primarily for ease of manufacture (e.g. die casting) of the ECU housing and not required for operation.

Particular dimensions of interest include: the depth of cavity 21, which may be up to about 30mm; the distance/clearance between the cover 12 and the hook 21, which may be up to 5 mm; the hook's internal radius, which may be from 0.4 mm up to 2.5 mm; and the hook's width across, which may be from 1 mm up to 40 mm.

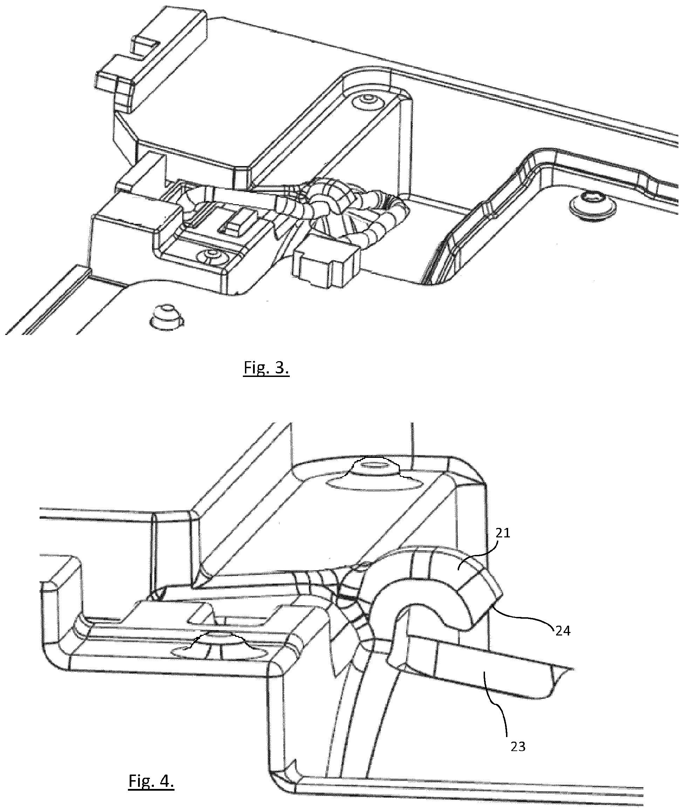

The internal radius of hook 21 is best seen in Figure 4, where it will be apparent that the hook should surround and enclose approximately half of a round cable that is compatible to be received within the radius. Particularly, a distal end 24 of the cable guide should extend so that a hook shape is formed, although the guide could more broadly be defined as an overhanging element with a means to engage a cable.

The invention facilitates a method of assembling an electronic control unit. Electronic devices can be assembled into the housing in the normal way. The cable is then typically routed by hand from the second device, through the guide, and plugged into the first device. Cover 12 is then fixed over the cavity to complete assembly.

By way of summary, a hook shaped guide in an ECU is described herein. An electronic control unit, ECU, comprises: a housing for housing a first electronic device, such as a PCB/processor, and a second electronic device, such as a fan unit, connected to each other by a cable. A cavity within the housing accommodates part of the cable and includes an overhanging guide element, e.g. with a hook shape, that engages with the cable and prevents it from becoming trapped against a cover during assembly.

## Claims

1. A housing for an electronic control unit, ECU, comprising:
a cavity within the housing, for accommodating at least part of a length of a cable electrically communicating between first and second electronic devices, the cavity having an opening configured for receiving a cover to close the cavity and be fixable to the housing; and
a hook shaped cable guide extending from or adjacent a wall of the cavity and configured for engagement with at least part of the length of the cable.

2. The housing according to claim 1, wherein an internal shape of the hook is configured to be compatible with and hold the cable.

3. The housing according to claim 2, wherein the internal shape has a curvature, configured to be compatible with a tubular cable.

4. The housing according to claim 2 or 3, wherein the internal shape of the hook is selected to provide an opening of at least more than a quarter and less than three quarters of the circumference of the cable it is configured to accommodate.

5. The housing according to any preceding claim, wherein the hook shaped cable guide is positioned to have a clearance from the opening.

6. The housing according to any preceding, wherein the hook shaped cable guide is configured to engage across a portion of the length of the cable.

7. The housing according to any preceding claim, wherein the hook shaped cable guide is integrally formed with the housing.

8. The housing according to claim 7, wherein the housing, with hook and cavity, is die-cast.

9. An ECU comprising the housing according to any preceding claim, further comprising: the first electronic device housed within the housing; the second electronic device housed within the housing or mounted thereto; a cover closable over the opening; and the cable electrically communicating between the first and second electronic devices.

10. The ECU according to claim 9, wherein the cable guide holds the cable in a separated position from the cover.

11. The ECU according to claim 9 or 10, wherein the second electronic device is a fan unit.

12. The ECU according to any preceding claim 9 to 11, wherein an edge of the opening and/or an edge/surface of the cover comprises a seal material.

13. A method of assembling an ECU according to any one of claims 9 to 12, comprising the steps of:
introducing the first electronic device into the housing, securing same thereto;
introducing the second electronic device into or mounted onto the housing;
routing the cable from the second electronic device to the first electronic device, including passing said cable under the hook shaped guide, and accommodating at least a portion of the length of the cable in the cavity;
affixing the cover over the opening to provide a closure to the cavity.
